# EUROPEAN PATENT SPECIFICATION

(11) **EP 1 588 141 B1**
(45) Date of publication and mention of the grant of the patent: **10.04.2013**
(21) Application number: 03790168.3
(22) Date of filing: 02.12.2003
(51) Int. Cl.: G01D 5/353

(54) **UNIVERSAL ACCESS PORT**
UNIVERSALANSCHLUSS
ORIFICE D'ACCES UNIVERSEL

(30) Priority: 05.12.2002 US 310358
(43) Date of publication of application: 26.10.2005
(73) Proprietor: Venturedyne Ltd., Milwaukee, Wisconsin 53227 (US)
(72) Inventor: SCHULZE, James, Plymouth, MA 02360 (US); EWING, Kevin, Holland, MI 49424 (US); PETERSON, Clinton, Holland, MI 49423 (US); WALKER, Richard, Hudsonville, MI 49426 (US); HAYES, Robert, Fruitport, MI 49415 (US)
(74) Representative: Caspary, Karsten
(86) International application number: PCT/US2003/038070
(87) International publication number: WO 2004/052074

(56) References cited:
- DE-A1- 19 617 697
- GB-A- 1 067 584
- GB-A- 2 276 152
- US-A- 3 712 078
- US-A- 4 156 146
- US-A- 4 949 031
- US-A- 5 461 831
- US-A- 6 120 371
- US-B1- 6 779 567

## Description

### Field of the Invention

The invention relates generally to conditioning enclosures and more specifically to a universal access port for conditioning enclosures, structured to receive numerous insertable devices.

### Background of the Invention

There are conventional conditioning enclosures, each having an opening created in a side thereof. A "conditioning enclosure" is defined as an oven, freezer, incubator, burn-in chamber, environmental test chamber, shaker, or other container that stresses or modifies an item inserted therein. Patent No. 4,854,726 to Lesley et al. discloses a thermal stress screening system. An exposure chamber is connected to a cabinet with a pair of insulated delivery hoses. Patent No. 4,949,031 to Szasz et al. discloses an environmental stress screening apparatus for electronic products. A product carrier pallet is inserted into an opening formed in an environmental test chamber. Patent No. 5,147,136 to Hartley et al. discloses a temperature cycling test chambers. A portion of the wall is rotable between two different test chambers.

US-3,712,078 discloses a refrigeration unit for a refrigerator. The refrigerating unit includes a chamber housing a heat exchanger. The chamber includes two openings of a similar shape and covers are provided that can be mounted over either opening. The refrigerating unit is located either on the bottom of a chest-style refrigerator cabinet or at the top of a front-opening, door-type refrigerator cabinet. An item to be refrigerated is placed within the refrigerator cabinet.

US-5,461,831 describes an assemblage and method for relieving overpressure in a machine processing enclosure to prevent damage to the machine itself. The machine processing enclosure has an opening that is surrounded by a cover. The opening varies and is sized relative to the particular volume of the machine processing enclosure and the cover for the opening. This cover includes an outer skin and a thermal barrier layer for providing insulation during normal operation of the machine processing enclosure. A gasket member is bonded to the thermal barrier layer between panel edges. The gasket member includes magnets encased in the outer layer for releasably sealing the cover to the machine processing enclosure. The gasket member further includes a bellows portion for accommodating warping of the cover caused by temperature changes during normal operation. There is an optional ferrous metallic material panel that is bolted around the opening of the machine enclosure.

US-6,779,567 discloses a rapid transfer port for enabling a worker to transfer an object through a sealed passageway from a canister to an isolation chamber without contaminating a clean work environment. The transfer port apparatus includes a canister portion and an isolator portion. The canister portion includes a canister passageway and is adapted to be coupled to the canister to place the canister passageway in communication with the canister chamber formed in the canister. The isolator portion includes an isolator passageway and is adapted to be coupled to the isolator to place the isolator passageway in communication with the isolation chamber formed in the isolator. A latch couples the canister portion to the isolator portion placing the canister passageway in communication with the isolator passageway, thereby forming a transfer conduit. After the canister and isolator are coupled, expandable airtight seals and doors are removed so that an object can be transferred through the conduit. Material can then be transferred between the canister chamber and the isolation chamber via the transfer conduit. After the transfer is complete, the airtight seals and doors are replaced.

US-6,120,371 discloses a system for transferring materials from a localized modular isolation container environment to a clean processing environment. The system includes a docking and environmental purging system for purging a modular isolation container for substrates used in manufacturing integrated circuits of particular contaminants and docking the isolation container with a processing environment free of particulate contaminants. The isolation container includes a chamber for isolating a substrate and it has a door, which when opened, provides access to the chamber. The door portion is pivotally mounted to the housing. The system includes a main housing defining a docking chamber connected for communication with the processing environment for receiving the isolation container. The housing is typically mounted to or adjacent a wall of the processing environment to provide a contaminant free, sealed access to the processing environment.

There is a need for a universal access port formed in a side of a conditioning enclosure, such universal access port having a specific size and shape to receive a window, wire access device, bulkhead connector, manual manipulation device, door, junction box, shelf, rack, drawer, blowers, slave test chamber, and/or other insertable devices.

### Summary of the Invention

According to the invention, this is achieved by the modular environmental test system according to claims 1-6 and corresponding method according to claims 7-8.

As a result of implementing the present invention, a modular system may be implemented with high efficiency.

The foregoing summary does not limit the invention, which is instead defined by the attached claims.

### Brief Description of the Drawing Figures

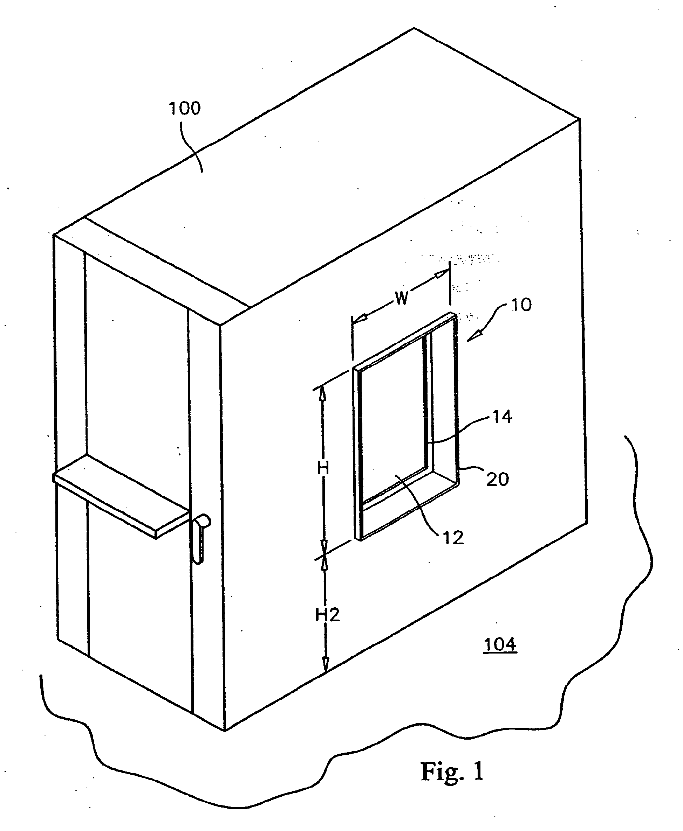

FIGURE 1 is a perspective view of a conditioning enclosure with a universal access port in accordance with the present invention.
FIGURE 2 is a perspective view of a sealing panel for insertion into a universal access port of a conditioning enclosure in accordance with the present invention.
FIGURE 3 is a cross sectional view of a sealing panel attached to a universal access port of a conditioning enclosure in accordance with the present invention.
FIGURE 4 is a perspective view of a drawer device for insertion into a universal access port of a conditioning enclosure in accordance with the present invention.
FIGURE 5 is a perspective view of a wire access device for insertion into a universal access port of a conditioning enclosure in accordance with the present invention.
FIGURE 6 is an interior perspective view of a blower device for insertion into a universal access port of a conditioning enclosure in accordance with the present invention.
FIGURE 6A is an exterior perspective view of a blower device for insertion into a universal access port of a conditioning enclosure in accordance with the present invention.
FIGURE 7 is a perspective view of a junction device for insertion into universal access ports of two environmental test chambers in accordance with the present invention.
FIGURE 8 is a front view of a first conditioning enclosure connected to a roll-up, walk-in conditioning chamber with a junction device in accordance with the present invention.
FIGURE 9 is a front view of three conditioning enclosures connected together with two junction devices in accordance with the present invention.
FIGURE 10 is a perspective view of a damper device for insertion into a universal access port of one conditioning enclosure and mating with two dampers on another conditioning enclosure in accordance with the present invention.
FIGURE 11 is a perspective view of a conditioning enclosure with two dampers.

### Detailed Description of the Preferred Embodiments

With reference to the drawings, there is shown a perspective view of a conditioning enclosure 100 with a universal access port 10. Universal access port 10 preferably includes an opening 12 of a specific width "W" and height "H" formed through a wall 102 of the conditioning enclosure 100. Universal access port 10 is disclosed as having a rectangular shape, but other shapes may also be used. Preferably, an interior peripheral flange 14 extends from an interior wall 102. Interior peripheral flange 14 surrounds the perimeter of the opening 12. A perimeter sealing gasket 16 is attached to the interior peripheral flange 14. Preferably, a perimeter sealing ridge 20 extends from a peripheral wall 18 of opening 12. A bottom of opening 12 is located at a height "H2 " from a floor or mounting surface 104 of conditioning enclosure 100.

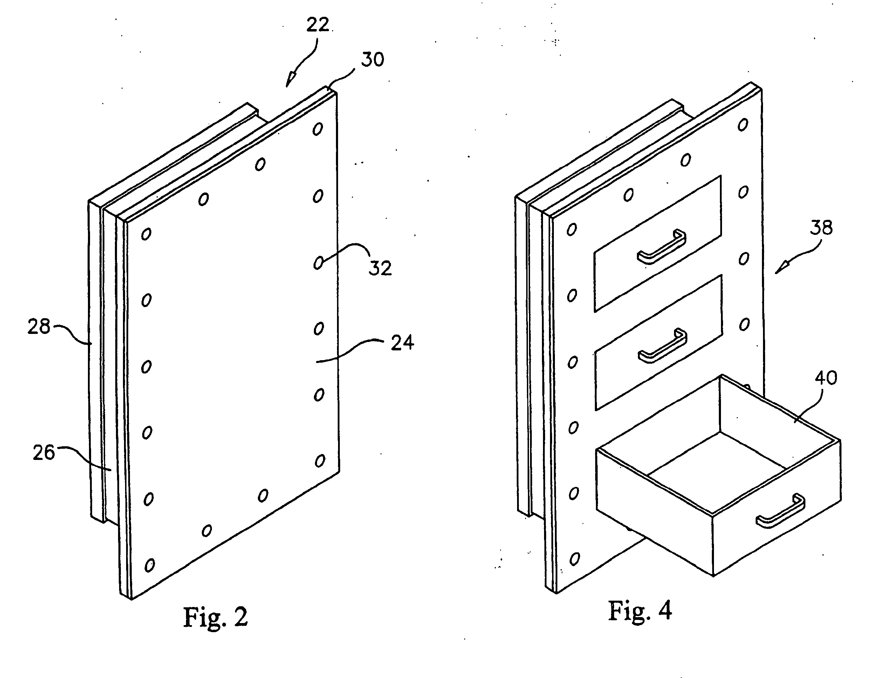

With reference to FIG. 2, when not in use, the universal access port 10 is covered with a sealing panel 22. The sealing panel 22 preferably includes a mounting plate 24, an insulated insert 26, a panel perimeter sealing ridge 28, and a panel perimeter sealing gasket 30. A plurality of mounting holes 32 are formed near the perimeter of the mounting plate 24. A plurality of fasteners 34 are inserted through the plurality of mounting holes 32 to retain the sealing panel 22 in the universal access port 10. The insulated insert 26 extends from a back of the mounting plate 24. The insulated insert 26 preferably contains an equivalent amount of insulation 36 found in the walls 102 of the conditioning enclosure 100. The panel perimeter sealing ridge 28 is attached to a perimeter of the insulated insert 26. The panel perimeter sealing ridge 28 seals against the perimeter sealing gasket 16 and the perimeter sealing ridge 20 seals against the panel perimeter sealing gasket 30. One method of sealing the sealing panel 22 (and other insertable devices) to the universal access port 10 is disclosed; however other methods of sealing may also be used.

FIGS. 4 - 7 disclose sealing panels which have been modified to form insertable devices. FIG. 4 discloses a drawer device 38. A plurality of drawers 40 are slidably retained in the drawer device 38. The plurality of drawers 40 are capable of holding a plurality of small parts for environmental testing. The plurality of parts are placed in each drawer 40. A back of the drawer will be exposed to an inside atmosphere of an environmental chamber. The plurality of small parts are removed after the environmental testing has been performed. The drawer device 38 includes all of the sealing and attachment features of the sealing panel 22.

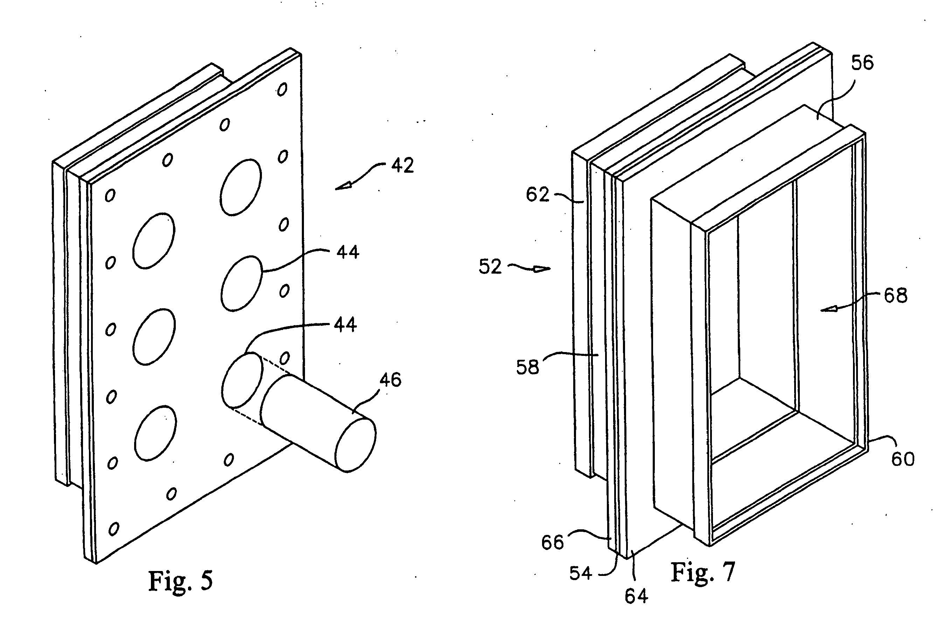

FIG. 5 discloses a wire access device 42. A plurality of through passages 44 are formed through wire access device 42. Each through passage 44 is sized to firmly receive a single sealing insert 46. Each sealing insert 46 is preferably fabricated from foam, but other materials may also be used. Each sealing insert 46 is capable of sealing around wires or other lines that need to be run through the wall 102 of the conditioning enclosure 100. A round through passage 44 is disclosed, but the through passage may also have other shapes. Wire access device 42 includes all of the sealing and attachment features of sealing panel 22.

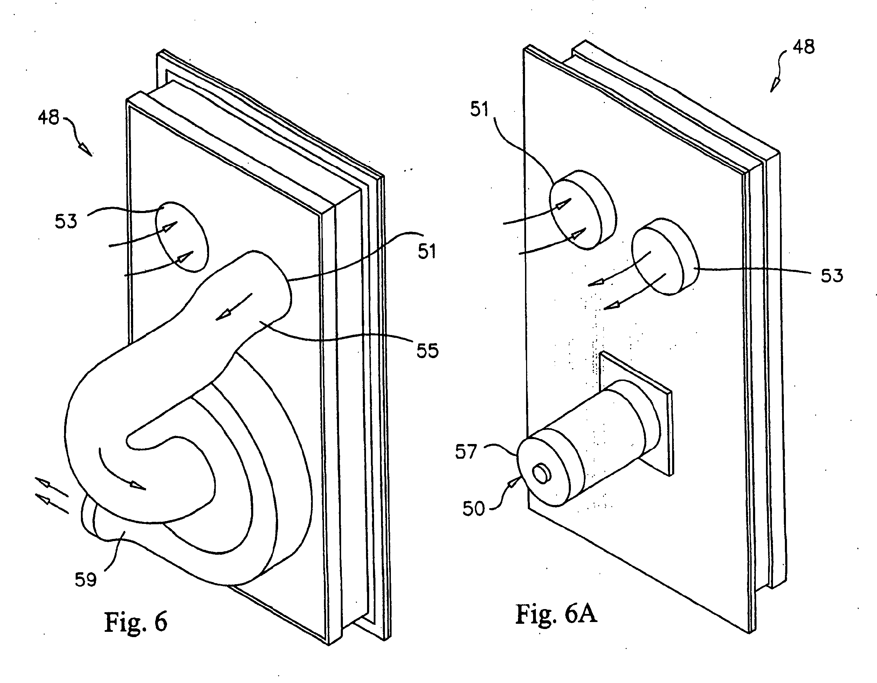

FIGS. 6 and 6A disclose a blower device 48. Blower device 48 includes an air blower 50, an input port 51, an output port 53, and an input duct 55. The air blower 50 includes a motor 57 and an air impeller 59. An input duct (not shown) is preferably connected between a source of conditioned air and input port 51. An output duct (not shown) is preferably connected between the source of conditioned air and the output port 53. Motor 57 turns a fan inside the air impeller 59 to draw air from input port 51 through input duct 55 to propel conditioned air substantially perpendicular to the output port 53. The blower device 48 includes all of the sealing and attachment features of sealing panel 22.

FIG. 7 discloses a junction device 52. Junction device 52 includes a mounting plate 54, a first insulated insert 56, a second insulated insert 58, a first panel perimeter sealing ridge 60, a second perimeter panel sealing ridge 62, a first panel perimeter sealing gasket 64, and a second panel perimeter sealing ridge 66. The first insulated insert 56 extends from a first side of the mounting plate 54 and the second insulated insert 58 extends from a second side of the mounting plate 54. The first panel perimeter sealing ridge 60 is attached to a perimeter of the first insulated insert 56 and the second panel perimeter sealing ridge 62 is attached to a perimeter of the second insulated insert 58. The first panel perimeter sealing gasket 64 is attached to the first side of the mounting plate 54 and the second panel perimeter sealing gasket 66 is attached to the second side of the mounting plate 54. A through passage 68 is formed through the first insulated insert 56, the mounting plate 54 and the second insulated insert 58.

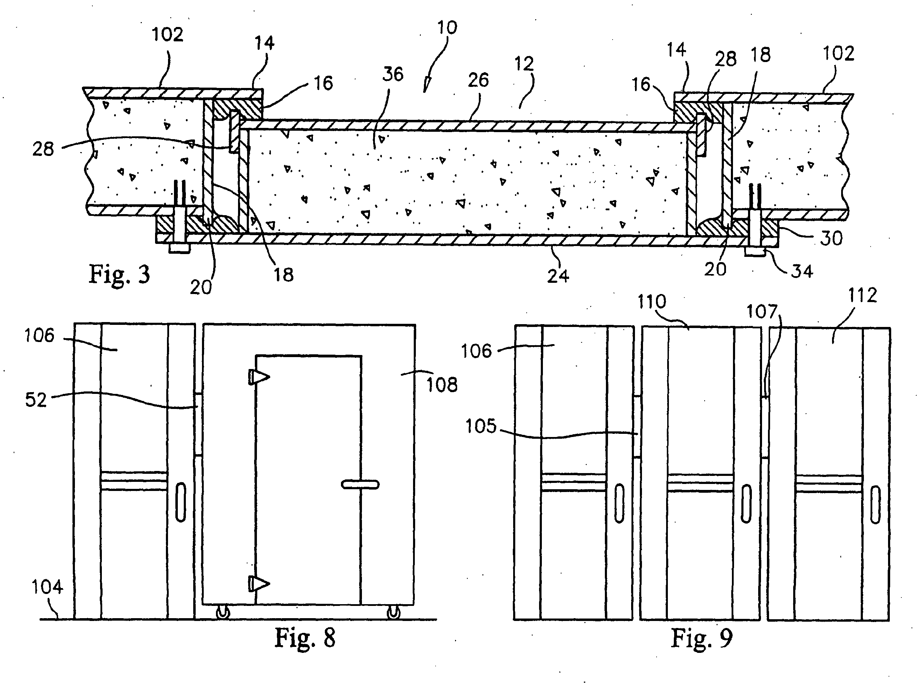

With reference to FIG. 8, the junction device 52 is used to connect a first conditioning enclosure 106 to a roll-up, walk-in conditioning enclosure 108. The first insulated insert 56 of the junction device 52 is inserted into a universal access port of the first conditioning enclosure 106 and a second insulated insert 58 of the junction device 52 is inserted into a universal access port of the roll-up, walk-in conditioning enclosure 108. The conditioning enclosures are pushed together to retain the junction device 52.

With reference to FIG. 9, three conditioning enclosures are connected in series with two junction devices. The first conditioning enclosure 106 is connected to one side of a second conditioning enclosure 110 with a first junction device 105 and a third conditioning enclosure 112 is connected to the other side of the second conditioning enclosure 110 with a junction device 107. The second conditioning enclosure 110 includes at least two universal access ports.

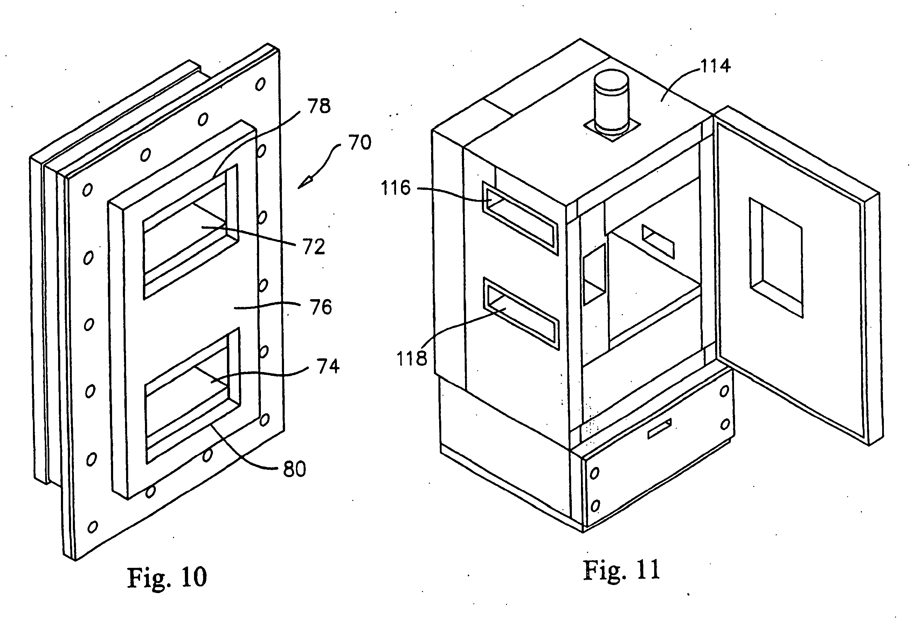

FIG. 10 discloses a damper device 70. Damper device 70 includes a first damper through passage 72, a second damper through passage 74, and a sealing gasket 76. A first passage opening 78 is formed through sealing gasket 76 to provide access to a damper through passage 72. A second passage opening 80 is formed through sealing gasket 76 to provide access to a damper through passage 74. The damper device 70 includes all of the sealing and attachment features of the sealing panel 22.

With reference to FIG. 11, a conditioning enclosure 114 is disclosed with a first damper 116 and a second damper 118 disposed on a side thereof. Damper device 70 is attached to the universal access port of a first conditioning enclosure (not shown). The conditioning enclosure 114 will be pushed against the sealing gasket 76, such that the first passage opening 78 is aligned with the first damper 116 and the second passage opening 80 is aligned with the second damper 118.

In modular fashion, the universal access port for conditioning enclosures receives standard sized insertable devices, thus increasing the versatility of one or more conditioning enclosures. A universal access port allows a conditioning enclosure to have expanded capacity by enabling a connecting of additional conditioning enclosures to the conditioning enclosure, whereby additional parts may be subjected to testing. Such additional conditioning enclosures are connected with a junction device inserted into the universal access ports of each conditioning enclosure. The additional conditioning enclosures may be used as auxiliary units and their functionality need not be the same as the first conditioning enclosure. For example, a capacity for performing temperature testing may be increased without the cost of additional conditioning enclosures that replicate unused functionality. A universal access port also provides modular assembly of a group of conditioning units each having different functions.

Each universal access port includes a specific size opening that is formed through a wall of a conditioning enclosure and located at a specific distance from a floor or mounting surface of the conditioning enclosure. The opening preferably has a rectangular shape, but other shapes may also be used. When not in use, the universal access port may be covered with a sealing panel. Insertable devices, including the sealing panel, maybe efficiently inserted and removed from the universal access port. A perimeter of an insertable device is sized to be sealably inserted into the universal access port. Each insertable device preferably seals with an exterior and with an interior wall of the conditioning enclosure. Some insertable devices include fixture devices, windows, manual manipulation devices, junction devices, hinged access doors, wire access devices, hydraulic connection devices, temperature modifying devices, air circulation devices, gas insertion devices, blower devices, and any other appropriate insertable device. Several types of insertable devices are herein disclosed, but the present system may include other types of insertable devices as well.

While the principles of the invention have been shown and described in connection with specific embodiments, it is to be understood that such embodiments are by way of example and are not limiting. Consequently, variations and modifications commensurate with the above teachings, and with the skill and knowledge of the relevant art, are within the scope of the present invention as defined by the claims. The embodiments described herein are intended to illustrate best modes known of practicing the invention and to enable others skilled in the art to utilize the invention in such, or other embodiments and with various modifications required by the particular application(s) or use(s) of the present invention.

## Claims

1. A modular environmental test system, comprising:
an conditioning enclosure embodied as an environmental test chamber, formed by an insulated wall (102);
an opening (12) formed in the insulated wall (102) and extending between interior and exterior surfaces thereof, the opening (12) having a specific shape and size, such that the opening (12) is adapted to receive a plurality of interchangeable closure devices (22, 38, 42, 48, 52, 70); and
a plurality of interchangeable closure devices (22, 38, 42, 48, 52, 70) each adapted for being inserted into the opening (12) and adapted for a chamber-access function, chamber-interface function, chamber-manipulation function, or chamber-observation function,
**characterized in that**
each interchangeable closure device (22, 38, 42, 48, 52, 70) has a mounting plate (24), an insulated insert (26), a panel perimeter sealing ridge (28), and a panel perimeter sealing gasket (30), and
an interior peripheral flange (14) surrounds the perimeter of the opening (12), a perimeter sealing gasket (16) is attached to the interior peripheral flange (14), and a perimeter sealing ridge (20) extends from a peripheral wall (18) of the opening (12),
wherein each interchangeable closure device is sealingly engageable with the exterior surface of the wall (102) around a perimeter of the opening (12) by the panel perimeter sealing ridge (28) sealing against the perimeter sealing gasket (16) and by the perimeter sealing ridge (20) sealing against the panel perimeter sealing gasket (30).

2. The modular environmental test system of claim 1 including among the interchangeable closure devices (22, 38, 42, 48, 52, 70) at least one closure device serving a chamber-access function, each selected from among the group including a sealing panel (22), a closure panel with drawer assembly (38), a closure panel with wire-access device (42), a closure panel with damper assembly (70) and a closure panel with blower device (48).

3. The modular environmental test system of claim 2 wherein the closure panel with wire-access device (42) includes a plurality of through passages (44), and further a corresponding plurality of sealing inserts (46), each sealing panel (46) structured for being firmly received into a corresponding through passage (44).

4. The modular environmental test system of claim 3 wherein at least one of the plurality of sealing inserts (46) is formed of a foam material and is structured for sealing around wires being fed through the through passage (44).

5. The modular environmental test system of claim 1 including among the interchangeable closure devices (22, 38, 42, 48, 52, 70) at least one junction device (52) including a mounting plate (54), a first insulated insert (56) extending from a front of the mounting plate (52) and a second insulated insert (58) extending from a rear of the mounting plate (52), forming a through passage (68) though the mounting plate (52), the first insulated insert (54) and the second insulated insert (56).

6. The modular environmental test system of claim 1 wherein the interchangeable closure devices (22, 38, 42, 48, 52, 70) include a window.

7. A method of increasing the versatility of a conditioning enclosure, comprising the steps of:
- forming at least one opening (12) through a wall of said conditioning enclosure, the opening (12) having a specific shape and size, the conditioning enclosure stressing or modifying at least one item inserted therein for testing purposes;
- locating the opening (12) a specific distance from a floor or mounting surface of said conditioning enclosure;
- making the specific shape, specific size, and specific distance a standard for a plurality of conditioning enclosures; and
- providing an insertable junction device (52) sized to be received by the opening, the insertable junction device (52) including a mounting plate (54), a first insulated insert (56) extending from a front of the mounting plate (54) and a second insulated insert (58) extending from a rear of the mounting plate (54), forming a through passage through said mounting plate (54), said first insulated insert (56) and said second insulated insert (58),
- sealing the insertable junction device (52) to the opening (12), wherein the sealing includes forming a sealing gasket (16) on a perimeter of each one of the at least one opening (12) at an interior end thereof, and forming a sealing ridge (20) on a perimeter of the opening (12) at an exterior end thereof.

8. The method of claim 7 further comprising connecting the respective openings (12) of two of the plurality of conditioning enclosures (100) via the junction device (52).

## Patentansprüche

1. Modulares Umgebungsprüfsystem mit:
einem Behandlungsgehäuse, das als eine Umgebungsprüfkammer ausgebildet ist und durch eine isolierte Wand (102) gebildet ist;
einer Öffnung (12), die in der isolierten Wand (102) ausgebildet ist und sich zwischen inneren und äußeren Oberflächen davon erstreckt, wobei die Öffnung (12) eine besondere Form und Größe aufweist, so dass die Öffnung (12) geeignet ist, eine Mehrzahl von auswechselbaren Schließeinrichtungen (22, 38, 42, 48, 52, 70) aufzunehmen; und
einer Mehrzahl von auswechselbaren Schließeinrichtungen (22, 38, 42, 48, 52, 70), die jeweils zum Einsetzen in die Öffnung (12) geeignet sind und die für eine Kammerzugangsfunktion, Kammerschnittstellenfunktion, Kammermanipulationsfunktion oder Kammerbeobachtungsfunktion eingerichtet ist,
**dadurch gekennzeichnet, dass**
jede auswechselbare Schließeinrichtung (22, 38, 42, 48, 52, 70) eine Trägerplatte (24), einen Isoliereinsatz (26), eine Plattenumfangsdichtrippe (28) und eine Plattenumfangsdichtung (30) aufweist, und
ein Innenumfangsflansch (14) den Umfang der Öffnung (12) umgibt, eine Umfangsdichtung (16) an dem Innenumfangsflansch (14) befestigt ist und eine Umfangsdichtrippe (20) sich von einer Umfangswand (18) der Öffnung (12) erstreckt,
wobei jede auswechselbare Schließeinrichtung dichtend mit der äußeren Oberfläche der Wand (102) um einen Umfang der Öffnung (12) herum mittels der Plattenumfangsdichtrippe (28), die gegen die Umfangsdichtung (16) abdichtet, und mittels der Umfangsdichtrippe (20), die gegen die Plattenumfangsdichtung (30) abdichtet, in Eingriff bringbar ist.

2. Modulares Umgebungsprüfsystem nach Anspruch 1, das unter den auswechselbaren Schließeinrichtungen (22, 38, 42, 48, 52, 70) mindestens eine Schließeinrichtung umfasst, die zu einer Kammerzugangsfunktion dient, die jeweils aus der Gruppe ausgewählt ist, die eine Abdichtplatte (22), eine Schließplatte mit Schubladenanordnung (38), eine Schließplatte mit Kabelzugangseinrichtung (42), eine Schließplatte mit Dämpferanordnung (70) und eine Schließplatte mit Lüftereinrichtung (48) umfasst.

3. Modulares Umgebungsprüfsystem nach Anspruch 2, wobei die Schließplatte mit Kabelzugangseinrichtung (42) eine Mehrzahl von Durchgängen (44) und des weiteren eine entsprechende Mehrzahl von Dichteinsätzen (46) umfasst, wobei jede Dichtplatte (46) dazu eingerichtet ist, fest in einem entsprechenden Durchgang (44) aufgenommen zu sein.

4. Modulares Umgebungsprüfsystem nach Anspruch 3, wobei mindestens einer der Mehrzahl von Dichteinsätzen (46) aus einem Schaumstoffmaterial gebildet ist und dazu eingerichtet ist, um Kabel herum abzudichten, die durch den Durchgang (44) geführt sind.

5. Modulares Umgebungsprüfsystem nach Anspruch 1, das unter den auswechselbaren Schließeinrichtungen (22, 38, 42, 48, 52, 70) mindestens eine Verbindungseinrichtung (52) umfasst, die eine Trägerplatte (54), einen ersten Isoliereinsatz (56), der sich von einer Vorderseite der Trägerplatte (52) erstreckt, und einen zweiten Isoliereinsatz (58) umfasst, der sich von einer Rückseite der Trägerplatte (52) erstreckt, wobei dadurch ein Durchgang (68) durch die Trägerplatte (52), den ersten Isoliereinsatz (54) und den zweiten Isoliereinsatz (56) gebildet ist.

6. Modulares Umgebungsprüfsystem nach Anspruch 1, wobei die auswechselbaren Schließeinrichtungen (22, 38, 42, 48, 52, 70) ein Fenster umfassen.

7. Verfahren zum Erhöhen der Vielseitigkeit eines Behandlungsgehäuses mit den folgenden Schritten:
- Bilden von mindestens einer Öffnung (12) durch eine Wand des Behandlungsgehäuses, wobei die Öffnung (12) eine besondere Form und Größe aufweist, wobei das Behandlungsgehäuse mindestens einen Gegenstand, der darin für Testzwecke eingefügt ist, beansprucht oder modifiziert;
- Anordnen der Öffnung (12) in einem bestimmten Abstand von einem Boden oder einer Montageoberfläche des Behandlungsgehäuses;
- Festlegen der bestimmten Form, der bestimmten Größe und des bestimmten Abstands für eine Mehrzahl von Behandlungsgehäusen als Standard; und
- Bereitstellen einer einfügbaren Verbindungsvorrichtung (52), die in ihrer Größe dimensioniert ist, um durch die Öffnung aufgenommen zu werden, wobei die einfügbare Verbindungsvorrichtung (52) eine Trägerplatte (54), einen ersten Isoliereinsatz (56), der sich von einer Vorderseite der Trägerplatte (54) erstreckt, und einen zweiten Isoliereinsatz (58) umfasst, der sich von einer Rückseite der Trägerplatte (54) erstreckt, wobei ein Durchgang durch die Trägerplatte (54), den ersten Isoliereinsatz (56) und den zweiten Isoliereinsatz (58) gebildet wird,
- Abdichten der einfügbaren Verbindungsvorrichtung (52) in der Öffnung (12), wobei das Abdichten das Bilden einer Dichtung (16) auf einem Umfang von jeder der mindestens einen Öffnung (12) an deren innerem Ende und das Bilden einer Dichtrippe (20) auf einem Umfang der Öffnung (12) an ihrem äußeren Ende umfasst.

8. Verfahren nach Anspruch 7, das des Weiteren das Verbinden der entsprechenden Öffnungen (12) von zwei der Mehrzahl von Behandlungsgehäusen (100) mittels der Verbindungsvorrichtung (52) umfasst.

## Revendications

1. Système d'essai environnemental modulaire, comprenant :
une enceinte de conditionnement réalisée sous la forme d'une chambre d'essai environnemental, formée par une paroi isolée (102) ;
une ouverture (12) formée dans la paroi isolée (102) et s'étendant entre des surfaces intérieure et extérieure de celle-ci, l'ouverture (12) ayant une forme et une taille spécifiques, de sorte que l'ouverture (12) est adaptée pour recevoir une pluralité de dispositifs de fermeture interchangeables (22, 38, 42, 48, 52, 70) ; et
une pluralité de dispositifs de fermeture interchangeables (22, 38, 42, 48, 52, 70), chacun étant adapté pour être inséré dans l'ouverture (12) et adapté pour une fonction d'accès à la chambre, une fonction d'interface avec la chambre, une fonction de manipulation de la chambre ou une fonction d'observation de la chambre,
**caractérisé en ce que**
chaque dispositif de fermeture interchangeable (22, 38, 42, 48, 52, 70) a une plaque de montage (24), un insert isolé (26), une nervure d'étanchéité de périmètre de panneau (28) et une garniture d'étanchéité de périmètre de panneau (30), et
un rebord périphérique intérieur (14) entoure le périmètre de l'ouverture (12), une garniture d'étanchéité de périmètre (16) est fixée au rebord périphérique intérieur (14), et une nervure d'étanchéité de périmètre (20) s'étend à partir d'une paroi périphérique (18) de l'ouverture (12),
dans lequel chaque dispositif de fermeture interchangeable peut s'engager de manière étanche avec la surface extérieure de la paroi (102) autour d'un périmètre de l'ouverture (12) par la nervure d'étanchéité de périmètre de panneau (28) réalisant l'étanchéité contre la garniture d'étanchéité de périmètre (16) et par la nervure d'étanchéité de périmètre (20) réalisant l'étanchéité contre la garniture d'étanchéité de périmètre de panneau (30).

2. Système d'essai environnemental modulaire selon la revendication 1, incluant parmi les dispositifs de fermeture interchangeables (22, 38, 42, 48, 52, 70), au moins un dispositif de fermeture servant de fonction d'accès à la chambre, chacun étant choisi parmi le groupe incluant un panneau d'étanchéité (22), un panneau de fermeture avec un ensemble de tiroirs (38), un panneau de fermeture avec un dispositif d'accès à des fils (42), un panneau de fermeture avec un ensemble de registres (70) et un panneau de fermeture avec un dispositif de soufflage (48).

3. Système d'essai environnemental modulaire selon la revendication 2, dans lequel le panneau de fermeture avec le dispositif d'accès à des fils (42) inclut une pluralité de passages traversants (44), et en outre une pluralité correspondante d'inserts d'étanchéité (46), chaque panneau d'étanchéité (46) étant structuré pour être reçu fermement dans un passage traversant (44) correspondant.

4. Système d'essai environnemental modulaire selon la revendication 3, dans lequel au moins un de la pluralité inserts d'étanchéité (46) est formé d'une matière en mousse et est structuré pour réaliser l'étanchéité autour de fils étant passés à travers le passage traversant (44).

5. Système d'essai environnemental modulaire selon la revendication 1, incluant parmi les dispositifs de fermeture interchangeables (22, 38, 42, 48, 52, 70), au moins un dispositif de jonction (52) incluent une plaque de montage (54), un premier insert isolé (56) s'étendant à partir d'un avant de la plaque de montage (52) et un second insert isolé (58) s'étendant à partir d'un arrière de la plaque de montage (52), formant un passage traversant (68) à travers la plaque de montage (52), le premier insert isolé (54) et le second insert isolé (56).

6. Système d'essai environnemental modulaire selon la revendication 1, dans lequel les dispositifs de fermeture interchangeables (22, 38, 42, 48, 52, 70) incluent une fenêtre.

7. Procédé pour accroître la polyvalence d'une enceinte de conditionnement, comprenant les étapes de :
- formation d'au moins une ouverture (12) à travers une paroi de ladite enceinte de conditionnement, l'ouverture (12) ayant une taille et une forme spécifiques, l'enceinte de conditionnement sollicitant ou modifiant au moins un article inséré dans celle-ci à des fins d'essai ;
- positionnement de l'ouverture (12) à une distance spécifique d'un sol ou d'une surface de montage de ladite enceinte de conditionnement ;
- standardisation de la forme spécifique, de la taille spécifique et de la distance spécifique pour une pluralité d'enceintes de conditionnement ; et
- fourniture d'un dispositif de jonction insérable (52) dimensionné pour être reçu par l'ouverture, le dispositif de jonction insérable (52) incluant une plaque de montage (54), un premier insert isolé (56) s'étendant à partir d'un avant de la plaque de montage (54) et un second insert isolé (58) s'étendant à partir d'un arrière de la plaque de montage (54), formant un passage traversant à travers ladite plaque de montage (54), ledit premier insert isolé (56) et ledit second insert isolé (58),
- étanchéification du dispositif de jonction insérable (52) sur l'ouverture (12), dans lequel l'étanchéification inclut la formation d'une garniture d'étanchéité (16) sur un périmètre de chacune de ladite au moins une ouverture (12) sur une extrémité intérieure de celle-ci, celle-ci, et la formation d'une nervure d'étanchéité (20) sur un périmètre de l'ouverture (12) sur une extrémité extérieure de celle-ci.

8. Procédé la revendication 7, comprenant en outre le raccordement des ouvertures respectives (12) de deux de la pluralité d'enceintes de conditionnement (100) via le dispositif de jonction (52).
